# FASCICULE DE BREVET EUROPEEN

(11) **EP 3 966 850 B1**
(45) Date de publication et mention de la délivrance du brevet: **18.01.2023**
(21) Numéro de dépôt: 20732259.5
(22) Date de dépôt: 24.04.2020
(51) Int. Cl.: H01L 21/48, H01L 23/373, H01L 23/46, H01L 23/498, H01L 25/07, B33Y 80/00, H01L 23/467, H01L 23/473

(54) **PROCEDE DE FABRICATION D'UN MODULE ELECTRONIQUE DE PUISSANCE**
VERFAHREN ZUR HERSTELLUNG EINES ELEKTRONISCHEN LEISTUNGSMODULS
METHOD FOR MANUFACTURING A POWER ELECTRONIC MODULE

(30) Priorité: 06.05.2019 FR 1904735
(43) Date de publication de la demande: 16.03.2022
(73) Titulaire: SAFRAN, 75015 Paris (FR)
(72) Inventeur: FEDI, Baptiste, Joël, Christian, 77550 MOISSY-CRAMAYEL (FR); KHAZAKA, Rabih, 77550 MOISSY-CRAMAYEL (FR); YOUSSEF, Toni, 77550 MOISSY-CRAMAYEL (FR); SALLOT, Pierre, Jean, 77550 MOISSY-CRAMAYEL (FR)
(74) Mandataire: Ernest Gutmann - Yves Plasseraud S.A.S.
(86) Numéro de dépôt international: PCT/FR2020/050709
(87) Numéro de publication internationale: WO 2020/225499

(56) Documents cités:
- DE-A1-102012 200 325
- FR-A1- 3 060 846
- FR-A1- 3 061 989

## Description

### Domaine technique de l'invention

L'invention concerne un procédé de fabrication d'un module électronique de puissance par fabrication additive ainsi qu'un module électronique de puissance obtenu à l'aide d'un tel procédé.

La présente invention trouve une application particulière dans le domaine de l'aéronautique où les contraintes thermiques peuvent être sévères.

### Etat de la technique antérieure

Les modules électroniques de puissance sont utilisés dans des convertisseurs nécessaires pour l'électrification des systèmes propulsifs et non propulsifs à bord des aéronefs afin de convertir l'énergie électrique du réseau principal (115V AC, 230V AC, 540V DC.) sous plusieurs formes (AC/DC, DC/AC, AC/AC et DC/DC).

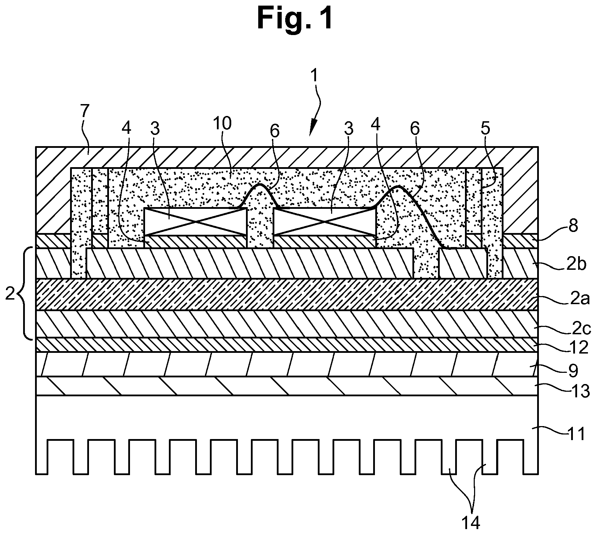

La figure 1 illustre un module électronique de puissance 1 de l'art antérieur. Celui-ci comporte un substrat 2 comportant une couche électriquement isolante 2a en matériau céramique, revêtu sur chacune de ses faces opposées d'une couche métallique 2b, 2c. Un tel ensemble est appelé substrat métallisé 2.

La couche métallique supérieure 2b forme un circuit de puissance sur lequel des composants à semi-conducteur de puissance 3 sont assemblés. Le module électronique de puissance 1 comprend un joint d'interconnexion électrique et/ou mécanique 4 par l'intermédiaire duquel les composants à semi-conducteur de puissance 3 et des connectiques 5 sont assemblés au circuit de puissance. Du fait de leurs imperfections, les composants à semi-conducteurs de puissance 3 sont le siège de pertes par effet Joules et représentent donc une source importante de chaleur.

Les composants à semi-conducteurs de puissance 3 sont interconnectés électriquement entre eux et avec les connectiques 5 à l'aide des fils de câblage 6. Un boîtier 7, généralement en polymère, est collé à l'aide d'un joint adhésif 8 sur le substrat 2 ou sur une semelle 9 métallique sur laquelle est disposée le substrat 2. Le boîtier 7 est rempli par un encapsulant 10, tel qu'un gel ou époxy, pour assurer une protection mécanique et électrique des composants de puissance 3 et des fils de câblage 6.

La couche métallique inférieure 2c du substrat 2 est rapportée sur la semelle 9 métallique qui a pour rôle d'étaler le flux thermique et d'assurer une connexion thermique avec un dissipateur thermique 11 métallique. Comme cela est illustré sur la figure 1, le module électronique de puissance 1 comprend un joint d'interconnexion électrique et/ou mécanique 12 par l'intermédiaire duquel la couche métallique 2c inférieure du substrat 2 est rapportée sur la semelle 9.

La semelle 9 est elle-même rapportée sur le dissipateur thermique 11 par l'intermédiaire d'une couche 13 de matériau d'interface thermique, telle qu'une graisse thermique, un film élastomère, ou des matériaux à changement de phase. La couche 13 de matériau d'interface thermique permet de réduire la résistance thermique de contact entre la semelle 9 et le dissipateur thermique 11 pour assurer une meilleure évacuation du flux thermique. Le dissipateur thermique 11, est muni d'ailettes 14 permettant de réduire d'autant plus la résistance thermique de ce dernier, les ailettes 14 étant traversées par un fluide de refroidissement, par exemple de l'air.

Un tel empilement de couches présente plusieurs limitations dans le cadre d'une utilisation à de hautes températures.

Une première limitation est la forte résistance thermique due au matériau d'interface thermique 13, en particulier dans le cas où un matériau d'interface thermique souple est utilisé (graisse thermique par exemple), et aux différentes interfaces séparant le composant de puissance 3 et le fluide de refroidissement.

Une seconde limitation est liée à une instabilité à haute température, limitée en particulier par la température de fonctionnement de l'interface thermique 13 (de l'ordre de 50°C dans le cas d'une graisse thermique).

Une troisième limitation correspond à une fiabilité limitée de l'assemblage due au phénomène de fatigue thermique, du fait de la différence entre les coefficients de dilatation thermique des matériaux. Dans le cas de l'utilisation de matériaux d'interface rigides, cette fatigue est une source de propagation de fissures dans la brasure, notamment entre le substrat 2 et la semelle 9 et entre la semelle 9 et le dissipateur thermique 11.

Des solutions basées sur le refroidissement direct du substrat métallisé par un fluide sont proposées dans la littérature, mais ces dernières présentent des limitations au niveau de la surface d'échange notamment.

Afin de pallier ces inconvénients, le document FR 3 061 989, au nom de la Demanderesse, propose d'utiliser la fabrication additive par la fusion d'un lit de poudre pour la réalisation du dissipateur thermique du boitier et des connectiques électriques directement et respectivement sur la face inférieure et supérieure du substrat métallisé. Cette technique permet de réduire les résistances thermiques de l'ensemble et de limiter les étapes d'assemblage. Cependant, la fusion du lit de poudre métallique nécessite des températures assez élevées localement lors du procédé, menant à des contraintes résiduelles importantes. Ces contraintes peuvent mener, pour certaines géométries, à la fissuration de la couche de céramique du substrat métallisé. De plus la température élevée générée par ce procédé limite le choix des substrats aux céramiques métallisées. Par ailleurs il n'est pas possible de réaliser des éléments par fabrication additive simultanément sur les deux faces opposées du substrat, de sorte qu'une intervention de l'opérateur est nécessaire pour retourner le substrat.

### Présentation de l'invention

L'invention vise à remédier à ces inconvénients, de manière simple, fiable et peu onéreuse. A cet effet, l'invention concerne un procédé de fabrication d'un module électronique de puissance par fabrication additive, caractérisé en ce qu'il comporte les étapes consistant à :
- réaliser ou fixer des préformes en matériau polymère sur au moins une face d'un substrat isolant recouvert d'au moins une couche de métal, appelé substrat métallisé,
- déposer une première couche métallique sur la préforme,
- déposer par électroformage une seconde couche métallique sur la première couche métallique.

Le procédé de fabrication peut être réalisé sur un substrat isolant métallisé de façon à obtenir des éléments de refroidissement, de connexion électrique et/ou de protection mécanique d'un module électronique de puissance par fabrication additive.

Un tel procédé peut permettre de réaliser plusieurs éléments en parallèle (radiateur, boitier et connectiques de puissance, par exemple).

Pour un même module électronique de puissance, tous les éléments précités ou des combinaison ou groupes d'éléments peuvent être imprimés simultanément ou successivement en utilisant le procédé décrit.

Les préformes peuvent être réalisées par fabrication additive. Les préformes peuvent être réalisées ou fixées sur au moins deux faces opposées du substrat métallisé.

La seconde couche peut présenter une épaisseur comprise entre quelques microns et quelques millimètres, en fonction des besoins. Il est possible de faire varier l'épaisseur de la seconde couche en fonction la tension appliquée et du temps de polarisation appliqué lors de l'étape de déposition par électroformage.

Lors du dépôt par électroformage, tout ou partie du substrat métallique et de la première couche métallique peut être plongée dans un bain électrolytique comportant des ions métalliques, par exemple du cuivre sous forme ionique. Une électrode est reliée électriquement à la première couche métallique, un potentiel électrique étant appliqué à ladite électrode de façon à déposer le métal d'apport du bain électrolytique sur la première couche métallique. Les zones non métalliques du substrat qui ne sont pas au potentiel de l'électrode ne sont alors pas recouvertes de métal d'apport.

Le procédé peut comporter une étape de dissolution des préformes en matériau polymère par voie chimique ou par voie thermique.

Il est ainsi possible de réaliser des zones en creux, des connectiques ou des canaux dans le module électronique de puissance ainsi obtenu. Les canaux peuvent notamment permettre de faciliter les échanges thermiques en vue du refroidissement de l'ensemble, par exemple par l'intermédiaire d'un flux d'air de refroidissement ou d'un fluide de refroidissement liquide.

Le procédé peut comporter une étape d'assemblage de composants actifs, tels par exemple que des composants de puissance à semi-conducteurs, sur le substrat métallisé.

Le composant actif peut être assemblé au substrat métallisé par frittage, collage ou frittage. Au moins deux composants actifs peuvent être reliés l'un à l'autre par des fils de câblage. Le procédé peut comporter une étape de protection d'au moins une zone du substrat métallisé avant dépôt de la première couche métallique.

La zone à protéger peut être recouverte d'un film réalisé par exemple en polymère. Ledit film peut être retiré lors de l'étape de dissolution des préformes.

Le substrat métallisé peut comporter au moins une couche isolante en céramique.

La ou les couches métalliques du substrat métallisé peuvent être assemblées à la couche isolante par brasage (ou en terminologie anglo-saxonne « Active Metal Brazing » ou « AMB), par liaison directe de cuivre (ou en terminologie anglo-saxonne « Direct Bonded Copper » ou « DBC »), ou encore par liaison directe d'aluminium (ou en terminologie anglo-saxonne « Direct Bonded Aluminium » ou encore « DBA »).

La couche isolante peut également être une couche de polymère.

La première couche métallique peut avoir une épaisseur inférieure à 5 microns, de préférence inférieure à 1 microns.

La première couche métallique peut être déposée sur la préforme par réduction chimique via aspersion.

Le module électronique de puissance peut comporter un boîtier dans lequel sont logés le substrat métallisé et le composant actif, le procédé comportant une étape de remplissage du boîtier, au moins en partie, à l'aide d'un matériau isolant électriquement.

Le matériau isolant est par exemple un gel à base de silicone ou de résine époxy.

L'invention concerne également un module électronique de puissance obtenu par le procédé du type précité, comportant un substrat métallisé et un composant actif monté sur une première face du substrat métallisé, un dissipateur thermique comportant des canaux de refroidissement s'étendant depuis une seconde face du substrat métallisé, opposée à la première face.

Le module électronique de puissance peut comporter au moins une connectique reliée électriquement au substrat métallisé.

La connectique peut être formée par un organe conducteur s'étendant depuis la première face du substrat métallisé.

Une partie de boîtier peut également s'étendre depuis la première face du substrat métallisé. La partie métallique du boîtier peut être réalisée lors de l'étape d'électroformage.

L'invention comporte également un aéronef comportant au moins un module électronique de puissance du type précité.

### Brève description des figures

[Fig. 1] est une vue schématique illustrant un module électronique de puissance de l'art antérieur,
[Fig. 2],
[Fig. 3],
[Fig. 4],
[Fig. 5] et
[Fig. 6] illustrent différentes étapes d'un procédé de fabrication d'un module électronique de puissance selon une forme de réalisation de l'invention.

### Description détaillée de l'invention

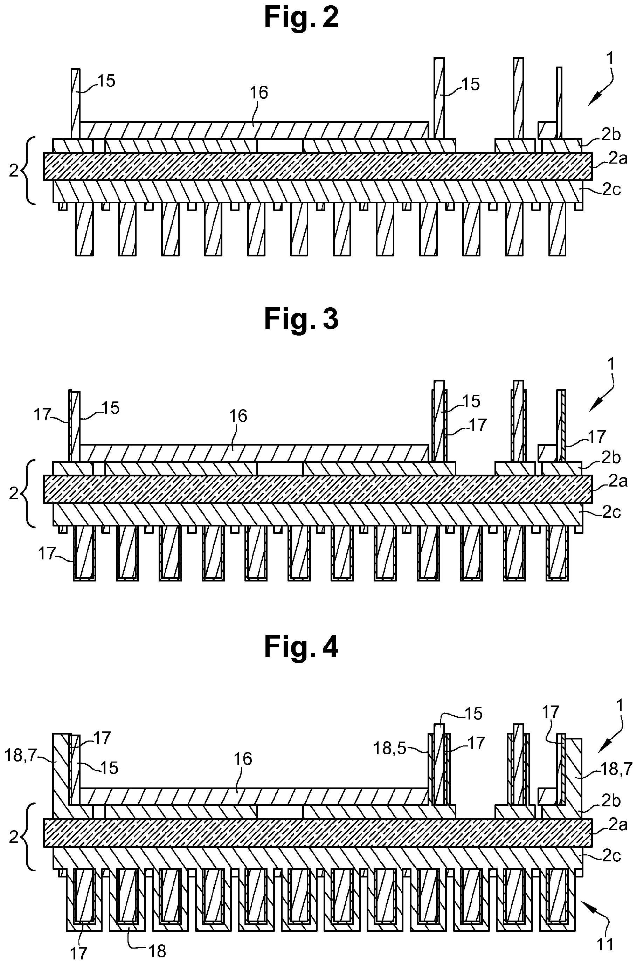

Les figures 2 à 6 illustrent schématiquement les différentes étapes de fabrication d'un module électronique de puissance 1 selon une forme de réalisation de l'invention.

Dans une première étape illustrée à la figure 2, des préformes 15 en matériau polymère sont réalisée par fabrication additive sur deux faces opposées d'un substrat métallisé 2. Les préformes 15 peuvent être réalisées directement sur le substrat métallisé 2 ou être attachées audit substrat métallisé 2 après réalisation des préformes 15. Dans ce dernier cas, les préformes 15 peuvent être collées au substrat métallisé 2.

Le substrat métallisé 2 comporte une couche électriquement isolante 2a en matériau céramique revêtue sur chacune de ses faces opposées d'une couche métallique 2b, 2c, par exemple en cuivre. Les couches métalliques 2b, 2c du substrat métallisé 2 peuvent être assemblées à la couche isolante 2a par brasage (ou en terminologie anglo-saxonne « Active Metal Brazing » ou « AMB), par liaison directe de cuivre (ou en terminologie anglo-saxonne « Direct Bonded Copper » ou « DBC »), ou encore par liaison directe d'aluminium (ou en terminologie anglo-saxonne « Direct Bonded Aluminium » ou encore « DBA »).

Les couches métalliques 2b, 2c peuvent former des pistes distinctes les unes des autres. Un film de protection 16 en matériau polymère peut recouvrir au moins une partie des pistes conductrices de la couche supérieure 2b.

En variante, la couche électriquement isolante 2a peut être réalisée en matériau polymère (dans le cas d'un substrat de type IMS ou Insulated Metal Substrate, en anglais).

Comme illustré à la figure 3, une première couche métallique 17, par exemple en cuivre, est ensuite déposée sur les préformes 15, par exemple par réduction chimique via aspersion. La première couche 17 présente une épaisseur inférieure à 1 microns par exemple.

Une seconde couche métallique 18, par exemple en cuivre, est ensuite déposée sur la première couche métallique 17, comme illustré à la figure 4. Un tel dépôt peut être réalisé par électroformage.

La seconde couche 18 peut présenter une épaisseur comprise entre quelques microns et quelques millimètres, en fonction des besoins. Il est possible de faire varier l'épaisseur de la seconde couche 18 en fonction la tension appliquée et du temps de polarisation appliqués lors de l'étape de déposition par électroformage.

Lors du dépôt par électroformage, tout ou partie du substrat métallisé 2 et de la première couche métallique 17 est plongée dans un bain électrolytique comportant des ions métalliques, par exemples du cuivre sous forme ionique. Le bain peut être un bain à basse température, c'est-à-dire à une température inférieure à 100°C. Une électrode est reliée électriquement à la première couche métallique 17, un potentiel électrique étant appliqué à ladite électrode de façon à déposer le métal d'apport du bain électrolytique sur la première couche métallique 17. Les zones non métalliques du substrat 2 qui ne sont pas au potentiel de l'électrode ne sont alors pas recouvertes de métal d'apport. Selon une variante de réalisation, au moins une partie de première couche métallique 17 est recouverte d'un film de protection de façon à empêcher le dépôt de la seconde couche métallique 18 dans la zone recouverte.

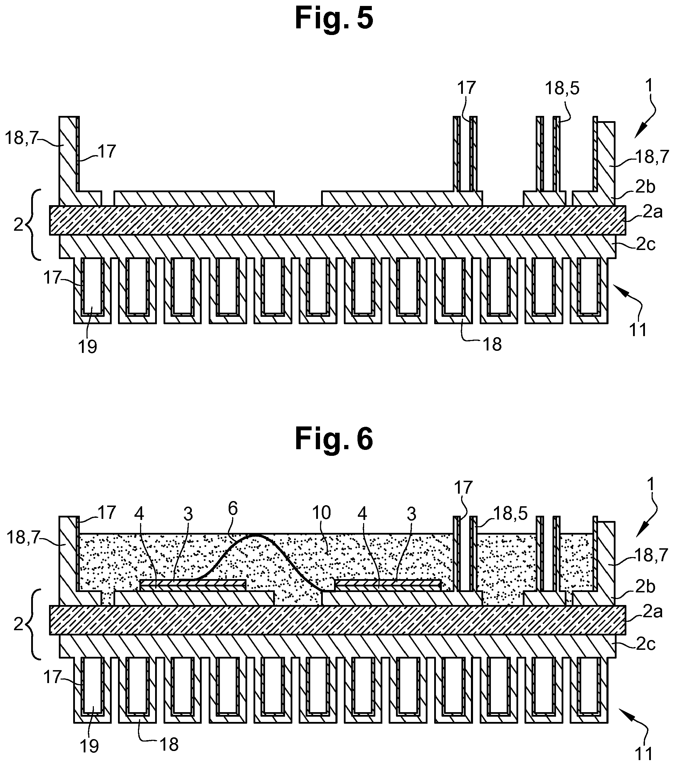

La seconde couche métallique 17 peut notamment délimiter des connectiques 5, des parties de boîtier 7 ou des canaux de refroidissement 19 d'un dissipateur thermique ou radiateur 11. Comme illustré à la figure 5, les préformes 15 sont ensuite retirées lors d'une étape de dissolution par voie chimique ou par voie thermique.

Dans le cas d'une dissolution par voie chimique, il est possible de réaliser la dissolution de préformes 15 en ABS à l'aide d'un bain d'acétone, à une température de 50°C et avec utilisation d'ultrasons.

En variante, pour réaliser la dissolution de préformes 15 en PLA, il est possible d'utiliser un bain de soude à 35%, à une température de 60°C, et de procéder à une agitation afin de favoriser la dissolution.

Il est ainsi possible de réaliser des zones en creux, les connectiques 5 ou les canaux 19 destinés à permettre de faciliter les échanges thermiques en vue du refroidissement de l'ensemble, par exemple par l'intermédiaire d'un flux d'air ou d'un fluide de refroidissement liquide.

Les films 16 peuvent être également retirés lors de l'étape de dissolution.

Les composants à semi-conducteur de puissance 3 sont ensuite assemblés aux pistes correspondantes du substrat métallisé 2 par l'intermédiaire d'un joint d'interconnexion électrique et/ou mécanique 4, comme cela est visible à la figure 6. Les composants de puissance 3 sont ensuite interconnectés électriquement entre eux et/ou avec les connectiques 11 à l'aide de fils de câblage 6. Le boîtier 7 est ensuite rempli par un encapsulant ou isolant électrique 10, tel qu'un gel ou époxy, pour assurer une protection mécanique et électrique des composants de puissance 3 et des fils de câblage 6.

Un tel procédé permet d'obtenir les avantages suivants :
- bonne performance thermique due notamment à la réduction des interfaces entre les composants à semi-conducteur 3 et le dissipateur thermique 11 et à la possibilité de réaliser un dissipateur thermique 11 présentant des formes géométriques complexes,
- possibilité d'utilisation à très haute température,
- amélioration de la fiabilité en éliminant les brasures sur des larges surfaces,
- augmentation de la densité de puissance massique des convertisseurs grâce à la réduction de la masse du dissipateur thermique 11,
- réduction du nombre d'étapes de fabrication et du temps de fabrication,
- réduction des contraintes résiduelles comparées à une même réalisation par des techniques de fabrication additive nécessitant des températures locales très élevées pour la fusion ou le frittage de poudres métalliques,
- étanchéité des canaux 19 du dissipateur thermique 11 grâce à l'absence de porosité et de lacune dans le matériau électro-déposé 18,
- bonne précision de l'électroformage, en terme de reproductibilité de l'état de surface. Ceci permet une grande liberté de texturation de surface via l'utilisation de préformes polymères 15 de géométries complexes obtenues par fabrication additive, augmentant fortement les surfaces d'échanges et donc les performances en termes de dissipation thermique,
- obtention d'un assemblage unitaire à basse température (< 80 °C) et en une seule phase incluant plusieurs fonctions (dissipateur thermique 11, boîtier 7, connectique 5) sur les deux faces de substrat isolant métallisé 2 sans venir rajouter des joints d'attache.

## Revendications

1. Procédé de fabrication d'un module électronique de puissance (1) par fabrication additive, **caractérisé en ce qu'**il comporte les étapes consistant à :
- réaliser ou fixer des préformes (15) en matériau polymère sur au moins une face d'un substrat isolant (2a) recouvert d'au moins une couche de métal (2b, 2c), appelé substrat métallisé (2),
- déposer une première couche métallique (17) sur la préforme (15),
- déposer par électroformage une seconde couche métallique (18) sur la première couche métallique (17).

2. Procédé selon la revendication 1, **caractérisé en ce qu'**il comporte une étape de dissolution des préformes en matériau polymère (15) par voie chimique ou par voie thermique.

3. Procédé selon la revendication 1 ou 2, **caractérisé en ce qu'**il comporte une étape d'assemblage de composants actifs, tels par exemple que des composants de puissance à semi-conducteurs (3), sur le substrat métallisé (2a).

4. Procédé selon l'une des revendications 1 à 3, **caractérisé en ce qu'**il comporte une étape de protection d'au moins une zone du substrat métallisé (2a) avant dépôt de la première couche métallique (17).

5. Procédé selon l'une des revendications 1 à 4, **caractérisé en ce que** le substrat métallisé (2) comporte au moins une couche isolante (2a) en céramique.

6. Procédé selon l'une des revendications 1 à 5, **caractérisé en ce que** la première couche métallique (17) a une épaisseur inférieure à 5 microns, de préférence inférieure à 1 microns.

7. Procédé selon les revendications 1 et 3, **caractérisé en ce que** le module électronique de puissance (1) comporte un boîtier (7) dans lequel sont logés le substrat métallisé (2) et le composant actif (3), le procédé comportant une étape de remplissage du boîtier, au moins en partie, à l'aide d'un matériau isolant électriquement (10).

## Patentansprüche

1. Verfahren zur Herstellung eines elektronischen Leistungsmoduls (1) durch additive Fertigung,
**dadurch gekennzeichnet, dass** es die folgenden Schritte umfasst:
- Herstellen oder Befestigen von Vorformlingen (15) aus Polymermaterial auf zumindest einer Seite eines mit zumindest einer Metallschicht (2b, 2c) bedeckten, isolierenden Substrats (2a), metallisiertes Substrat (2) genannt,
- Abscheiden einer ersten Metallschicht (17) auf dem Vorformling (15),
- Abscheiden einer zweiten Metallschicht (18) auf der ersten Metallschicht (17) durch Galvanoformung.

2. Verfahren nach Anspruch 1,
**dadurch gekennzeichnet, dass** es einen Schritt des Auflösens der Vorformlinge aus Polymermaterial (15) auf chemischem Wege oder thermischem Wege umfasst.

3. Verfahren nach Anspruch 1 oder 2,
**dadurch gekennzeichnet, dass** es einen Schritt des Anfügens von aktiven Komponenten, wie beispielsweise Halbleiter-Leistungsbauteilen (3), auf das metallisierte Substrat (2a) umfasst.

4. Verfahren nach einem der Ansprüche 1 bis 3,
**dadurch gekennzeichnet, dass** es einen Schritt zum Schutz zumindest eines Bereichs des metallisierten Substrats (2a) vor dem Abscheiden der ersten Metallschicht (17) umfasst.

5. Verfahren nach einem der Ansprüche 1 bis 4,
**dadurch gekennzeichnet, dass** das metallisierte Substrat (2) zumindest eine Isolierschicht (2a) aus Keramik aufweist.

6. Verfahren nach einem der Ansprüche 1 bis 5,
**dadurch gekennzeichnet, dass** die erste Metallschicht (17) eine Dicke von weniger als 5 Mikrometer, vorzugsweise weniger als 1 Mikrometer, aufweist.

7. Verfahren nach den Ansprüchen 1 und 3,
**dadurch gekennzeichnet, dass** das elektronische Leistungsmodul (1) ein Gehäuse (7) aufweist, in dem das metallisierte Substrat (2) und die aktive Komponente (3) aufgenommen sind, wobei das Verfahren einen Schritt umfasst, bei dem das Gehäuse zumindest teilweise mit einem elektrisch isolierenden Material (10) gefüllt wird.

## Claims

1. A method for manufacturing a power electronic module (1) by additive manufacturing,
**characterized in that** it comprises the steps of:
- making or fixing preforms (15) of polymer material on at least one face of an insulating substrate (2a) covered with at least one layer of metal (2b, 2c), referred to as a metallized substrate (2),
- depositing a first metal layer (17) on the preform (15),
- depositing by electroforming a second metal layer (18) on the first metal layer (17).

2. Process according to claim 1, **characterized in that** it comprises a step of dissolving the preforms of polymeric material (15) by chemical or thermal means.

3. A method according to claim 1 or 2, **characterized in that** it comprises a step of assembling active components, such as semiconductor power components (3), on the metallized substrate (2a).

4. A method according to any one of claims 1 to 3, **characterized in that** it comprises a step of protecting at least one zone of the metallized substrate (2a) before deposition of the first metal layer (17).

5. A method for any of the claims 1 to 4, **characterized in that** the metallized substrate (2) comprises at least one insulating layer (2a) of ceramic.

6. A method according to any of claims 1 to 5, **characterized in that** the first metal layer (17) has a thickness of less than 5 microns, preferably less than 1 micron.

7. A method according to claims 1 and 3, **characterized in that** the power electronic module (1) comprises a housing (7) in which the metallized substrate (2) and the active component (3) are housed, the method comprising a step of filling the housing, at least in part, with an electrically insulating material (10).
